# EUROPEAN PATENT APPLICATION

(11) **EP 1 975 997 A2**
(43) Date of publication of application: **01.10.2008**
(21) Application number: 08153643.5
(22) Date of filing: 28.03.2008
(51) Int. Cl.: H01L 21/677

(54) **Wafer transfer blade**

(30) Priority: 30.03.2007 JP 2007094552
(71) Applicant: Applied Materials, Inc., Santa Clara, CA 95054 (US)
(72) Inventor: Aoki, Yuji, Yokohama-shi Kanagawa 230-0014 (JP)
(74) Representative: Zimmermann & Partner

(57) **Abstract**

Projections 22 of the blade 16 provided on a blade surface in a wafer-loading region 18b of a body 18 support a wafer W loaded on the blade surface 18a. Since the projections 22 have microgrooves formed by surface roughening, the wafer W is retained on the projections 22 with a suppressed displacement. The blade 16 has a simple structure that retains the wafer W without vacuum suction and has no receiving hole to retain the wafer W in the body 18 of the blade 16. This can effectively prevent formation of defects on the wafer W.

## Description

The present invention relates to a wafer transfer blade used in a semiconductor manufacturing device.

A wafer transfer blade used in a semiconductor manufacturing device has required high-precision alignment. For example, a vacuum sucking blade, which sucks in the back surface of a wafer with a vacuum chuck to retain the wafer, is known.

A typical known blade for use in vacuum is a flat plate blade provided with a wafer-receiving hole. The wafer-receiving hole is designed such that the diameter of the wafer-receiving hole is slightly greater than that of a wafer to be loaded, and regulates displacement of the wafer on the side face of the wafer-receiving hole (Japanese Unexamined Patent Application Publication Nos. 2001-53135 and 6-181252).

However, this conventional blade has the following problems. Since the vacuum sucking blade is provided with a vacuum device, its configuration is complicated. Furthermore, in a blade provided with a receiving hole, the periphery of a wafer is put into contact with the side face of the receiving hole to regulate displacement of the wafer, thereby causing defects on the wafer during this operation.

The present invention is accomplished to solve the above problems and an object of the present invention is to provide a wafer transfer blade with a simple structure, which reduces defects on a wafer.
In light of the above, the waver transfer blade according to independent claim 1, and the wafer transfer blade according to independent claim 8 are provided.
Further advantages, features, aspects and details are evident from the dependent claims, the description and the drawings.

### Means for Solving the Problem

A wafer transfer blade in accordance with the present invention transfers a wafer that is loaded on the blade surface of a body of the blade, projections having top surfaces subjected to a surface roughening treatment are provided on the blade surface in a wafer-loading region of the body.

The projections of the wafer transfer blade, which are provided in the wafer-loading region on the blade surface of the body, support a wafer to be loaded on the blade surface. Since the top surfaces of the projections are subjected to a surface roughening treatment, the wafer is retained on the projections with a suppressed displacement. More specifically, the wafer transfer blade has a simple structure that retains a wafer without vacuum suction. In addition, since the blade to retain a wafer has no receiving hole in the blade body, defects on the wafer can be avoided.

In an embodiment, the material for the projections may be the same as that of the body. In such a case, the projections and the body have the same heat resistance and durability.

In another embodiment, the projections may be integrated to the body. In such a case, the structure of the blade is simplified, whereby the blade can be readily manufactured. When projections are separate pieces, an adhesive may be used to bond the projections to the body. This causes impurities to adhere on the wafer or the heat resistance to decrease. However, such problems can be avoided by providing projections integrated to the body.

In an embodiment, each of the projections may have serrated grooves formed by a surface roughening treatment and extending in one direction. In such a case, the resulting blade exhibits high wafer-retaining ability in a direction perpendicular to the grooves.

In an embodiment, the grooves on each projection may extend in a direction substantially perpendicular to the rotational direction of the wafer transfer blade. In general, the wafer-retaining ability in the rotational direction of the wafer transfer blade is critical. However, in the case of grooves extending in the direction substantially perpendicular to the rotational direction of the wafer transfer blade, displacement in the rotational direction is effectively suppressed.

In an embodiment, the grooves on each projection may be formed by grinding using #30-90 abrasive powder. Alternatively, in an embodiment, each projection may be subjected to sandblasting as the surface roughening treatment.

The wafer transfer blade in accordance with the present invention transfers a wafer loaded on the blade surface of the body of the blade, wherein at least a part of a wafer-loading region on the blade surface of the body is a roughened-surface region subjected to a surface roughening treatment, and the periphery of the wafer-loading region has a height not greater than that of the wafer-loading region.

The periphery of the wafer-loading region on the blade surface of the body has a height not greater than that of the wafer-loading region, whereby the wafer transfer blade retains the wafer in a roughened-surface region on the wafer-loading region. More specifically, the wafer transfer blade has a simple structure that retains a wafer without vacuum suction. In addition, since the blade to retain a wafer has no receiving hole in the blade body, defects on the wafer can be avoided.

In an embodiment, the entire wafer-loading region may be a roughened-surface region. In such a case, the resulting blade has high retaining ability.

In an embodiment, the roughened-surface region may have serrated grooves formed by a surface roughening treatment and extending in one direction. In such a case, the resulting blade has high wafer-retaining ability in a direction perpendicular to the grooves.

In an embodiment, the grooves formed on the roughened-surface region may extend in a direction substantially perpendicular to the rotational direction of the wafer transfer blade. In general, the wafer-retaining ability in the rotational direction of the wafer transfer blade is critical. However, in the case of grooves extending in the direction substantially perpendicular to the rotational direction of the wafer transfer blade, displacement in the rotational direction is effectively suppressed.

In an embodiment, the grooves on the roughened-surface region may be processed by grinding using #30-90 abrasive powder. Furthermore, in an embodiment, the roughened-surface region may be formed by sandblasting as the surface roughening treatment.

According to the present invention, the wafer transfer blade has a simple structure and can reduce defects on a wafer.
In an embodiment, projections of the blade provided on a blade surface in a wafer-loading region of a body support a wafer loaded on the blade surface. Since the projections have microgrooves formed by surface roughening, the wafer is retained on the projections with a suppressed displacement. The blade has a simple structure that retains the wafer without vacuum suction and has no receiving hole to retain the wafer in the body of the blade. This can effectively prevent formation of defects on the wafer.
Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.
Further, an embodiment may be directed to a method for fabricating a wafer transfer blade, in particular according to one of the claims 8 to 15, comprising: providing a wafer transfer blade for transferring a wafer loaded on the blade surface of a body of the blade and roughening at least a part of a wafer-loading region on the blade surface of the body.
So that the manner in which the above recited features of the present invention can be understood in detail, a more particular description of the invention, briefly summarized above, may be had by reference to embodiments. The accompanying drawings relate to embodiments of the invention and are described in the following:

The preferred embodiments of the present invention will now be described in detail with reference to the attached drawings. The same or equivalent similar elements are denoted by the same reference numerals and the overlapped explanation is omitted.

### (First Embodiment)

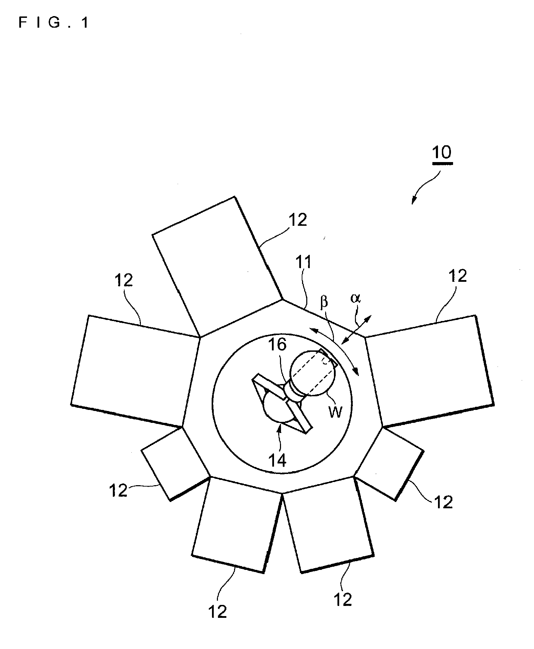

As shown in Fig. 1, a cluster tool 10 in accordance with the first embodiment of the present invention includes a transfer chamber 11 and a plurality of processing chambers 12 radially disposed around the transfer chamber 11. The transfer chamber 11 is provided with a transfer robot 14 to facilitate transfer of a wafer W between the processing chambers 12.

A blade 16 (wafer transfer blade), which transfers the wafer W (for example, silicon wafer having a diameter of 200 mm), is attached to the transfer robot 14. The transfer robot 14 moves the blade 16 in a direction away from and close to each processing chamber 12 (direction α in Fig. 1) and in a direction between the processing chambers 12 (direction β in Fig. 1).

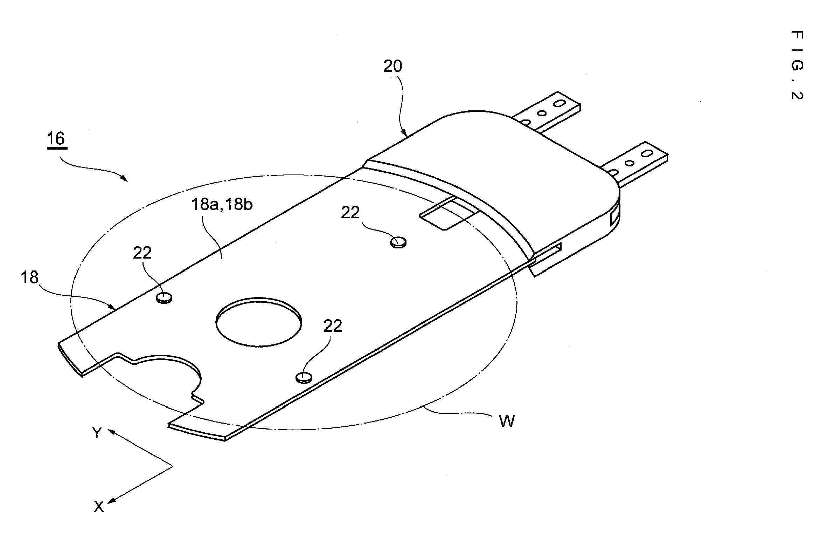

As shown in Fig. 2, the blade 16 includes a body 18 and a coupler 20 for retaining the body 18 and coupling the body 18 to the transfer robot 14.

The body 18 is a rectangular plate composed of SiC. The extending direction of the body 18 (direction X) substantially coincides with the advancing/retracting direction of the blade (direction α). The main surface 18a of the body 18 is the blade surface on which the wafer W is loaded. The wafer W loaded on the blade surface 18a of the body 18 is transferred. The wafer-loading region 18b on the blade surface 18a of the body 18 has three projections 22 integrated to the body 18. These projections 22 are formed, for example, during manufacturing of the body 18 by machining.

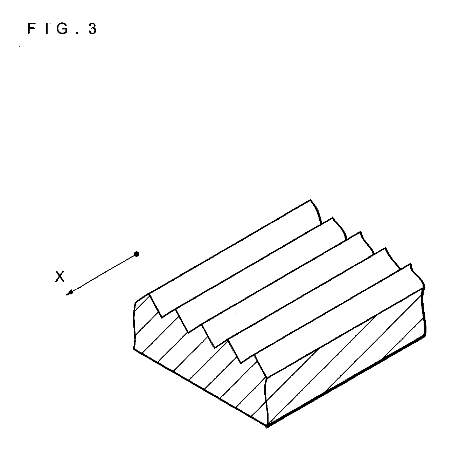

Three projections 22 include two projections 22 oriented in a transverse direction of the body 18 (direction Y, perpendicular to the extending direction of the body) and a projection 22 disposed on the bisector midway between the two projections 22. Each projection 22 has a cylindrical shape (a height of about 0.4 mm and a diameter of about 4 mm) extending normal to the blade surface 18a.
In a further embodiment, each projection 22 may have a cuboid shape. In a typical embodiment each projection may have a height of about 0.1 mm to 0.9 mm, in particular between 0.2 and 0.6 mm, typically 0.4 mm. In a further embodiment, each projection may have a diameter of 1 mm to 9 mm, in particular between 2mm and 6 mm, typically 4mm.
As shown in Fig. 3, the top surface of each projection 22 is subjected to a surface roughening treatment. More specifically, the top surface of each projection 22 has serrated microgrooves (a pitch of about 200 µm and a depth of about 100 µm) extending in the longitudinal direction of the body 18 (direction X).
In a further embodiment, the microgrooves have a pitch between about 150µm to 250µm, in particular between 170 µm and 220 µm, typically of 200µm. In a typical embodiment, the microgrooves have a depth between 50µm and 150µm, in particular between 75µm and 125µm, typically of 100 µm. In a further embodiment, each projection has wavelike microgrooves.
Such microgrooves can be formed by grinding using diamond abrasive powder. Diamond abrasive powder #60 according to Japanese Industrial Standards (JIS) R6001 (1998) was used. Alternatively, diamond abrasive powder #30-90 may also be used. Diamond abrasive powder that is coarser than #30 cannot sufficiently sharpen the peak edges on the microgrooves, whereas diamond abrasive powder that is finer than #90 cannot form peaks having a sufficient height.

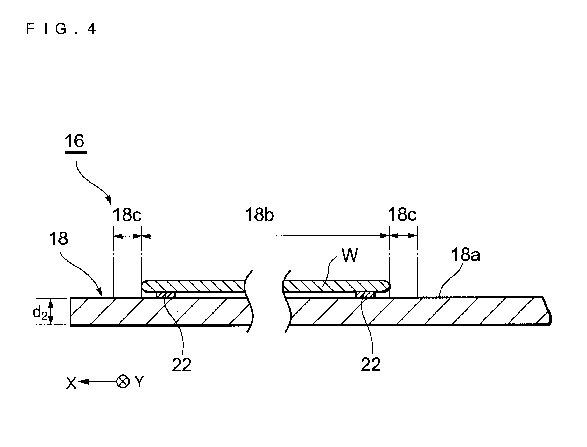

When the wafer W is loaded on the body 18 described above, as shown in Fig. 4, the wafer W is supported by only the projections 22 because the projections 22 are formed in the wafer-loading region 18b. The top surfaces of the projections 22, which are put into contact with the wafer W, have microgrooves formed by a surface-roughening treatment, whereby significant frictional force can be ensured between the wafer W and the projections 22. As a result, the wafer W is retained on the projections 22 with a suppressed displacement.

Since the microgrooves extend in the extending direction of the body 18 (direction X) along the advancing/retracting direction of the blade 16 (direction α in Fig. 1), the retaining ability associated with the rotational direction of the blade 16 (direction β in Fig. 1) is particularly improved. In the cluster tool 10 shown in Fig. 1, the acceleration and the final rate of the blade 16 is often higher in the rotational direction than in the advancing/retracting direction because of the moving distance. Consequently, the wafer-retaining ability of the blade 16 with respect to the rotational movement is critical. Hence, as described above, the projections 22 are provided with the microgrooves perpendicular to the rotational direction of the blade 16 (direction β) (that is, along the advancing/retracting direction of the blade 16 (direction α, direction X)). This can effectively suppress the displacement of the wafer W during the rotational transfer.

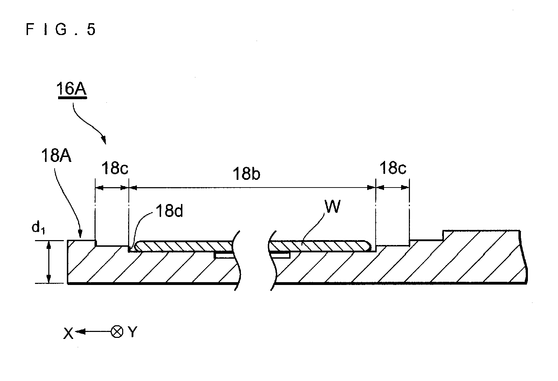

Fig. 5 shows a body 18A of a conventional blade 16A provided with a receiving hole 18d for accommodating the wafer W. In this conventional body 18A, the periphery 18c of the wafer-loading region 18b has a height greater than that of the wafer-loading region 18b. The periphery of the wafer W is put into contact with the side face of the receiving hole 18d, so that the body 18A regulates displacement of the wafer W. This contact of the wafer W with the side face of the receiving hole 18d causes partial defects on the wafer W.

However, in the body 18 in accordance with this embodiment, the wafer-loading region 18b has the same height as the periphery 18c of the wafer-loading region 18b, which effectively prevent the formation of defects on the wafer W. In addition, since the body 18 in accordance with the embodiment does not require the receiving hole 18d, unlike the conventional body 18A, the thickness d1 (1 mm for example) of the body 18 can be reduced compared to the thickness d2 (3 mm for example) of the conventional body 18. Such a reduction in thickness facilitates insertion of the body 18 of the blade 16 between wafers (for example, 5.5 mm interval) when the blade 16 handles the wafers W stacked in a cassette. In addition, the probability of contact of the body 18 of the blade 16 with the wafer W is significantly suppressed.

Furthermore, through experiments, the present inventors verified that the blade 16 in accordance with the embodiment reduces displacement of the loaded wafer W during the transferring operation compared to the conventional blade 16A provided with the receiving hole 18d under the same transferring conditions such as a transferring speed.

As explained in detail above, the projections 22 of the blade 16, which are provided on the blade surface in the wafer-loading region 18b of the body 18, support the wafer W loaded on the blade surface 18a. Since the projections 22 have the microgrooves formed by surface roughening, the wafer W is retained on the projections 22 with a suppressed displacement. That is, the blade 16 has a simple structure that retains the wafer W without vacuum suction and has no receiving hole to retain the wafer W in the body 18. This can effectively prevent formation of defects on the wafer W.

The projections 22 integrated to the body 18 simplify the structure of the blade 16 and facilitate production of the blade 16. When the projections 22 are separate pieces, an adhesive may be used to bond the projections 22 to the body 18. This causes impurities to adhere on the wafer W or the heat resistance to decrease. However, such problems can be avoided by the projections 22 integrated to the body 18. The projections 22 do not have to be integrated to the body 18 and may be separate pieces, if required.

Furthermore, since the material of the projections 22 is the same (SiC in this case) as that of the body 18, the projections 22 and the body 18 have the same heat resistance and durability. That is, the projections 22 and the body 18 formed of the same material (for example, SiC, Si0₂, Al₂O₃, glassy carbon (GC), TiO₂, or Al) ensure high heat resistance. Through the above-described surface roughening treatment, the inventors accomplished a blade 18 that had sufficient retaining ability and was able to transfer the wafer W successfully, even when the wafer W was supported by a material having high hardness used in the body 18. Resin materials cannot be used for the projections 22 because of low heat resistance. In particular, resin may be deteriorated (for example, deformed or melted) under high-temperature conditions such as deposition of the wafer W.

Furthermore, since the three projections 22 support the wafer W with a small surface contact area, the transfer of the material of the blade 16 or impurities therein onto the back surface of the wafer W is significantly suppressed. In particular, the top surfaces of the projections 22 are subjected to a surface roughening treatment to reduce the surface contact area between the wafer W and the blade 16, whereby such transfer is effectively suppressed.

When the blade 16 of the embodiment practically transferred the wafer W, three traces with only several micrometers in diameter were left on the back surface of the wafer W at positions corresponding to the three projections 22. This represents that the entire top surfaces of the projections 22, which are subjected to a surface roughening treatment, are not in contact with the back surface of the wafer W. Only the microregions of the top surfaces of the projections 22 are in contact with the back surface of the wafer W. As a result, the microregions of the projections 22 support the wafer W. That is, in practice, the area where the wafer W is in contact with the blade 16 is extremely smaller than the top surfaces of the projections.

### (Second Embodiment)

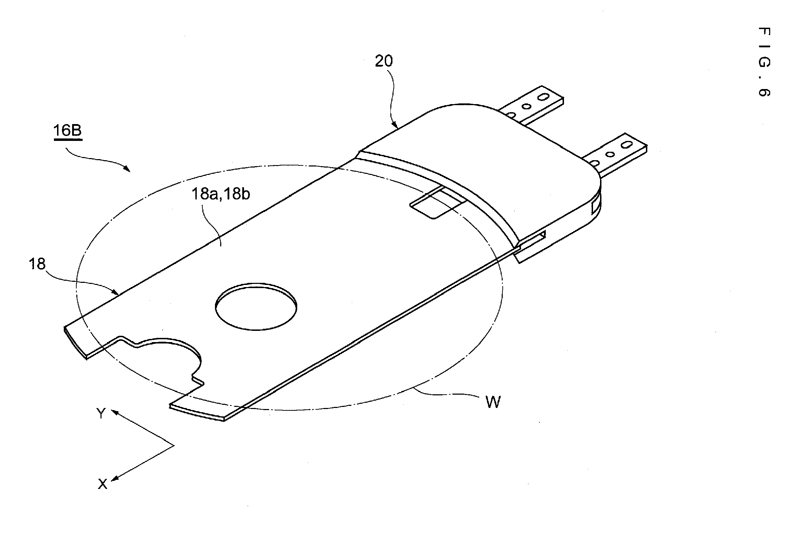

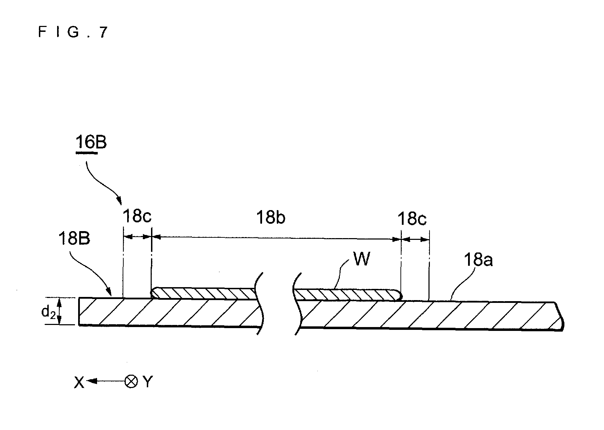

The second embodiment in accordance with the present invention will now be described with reference to Figs. 6 and 7. Fig. 6 is a perspective view illustrating a blade 16B in accordance with the second embodiment. Fig. 7 is a schematic sectional view illustrating the blade 16B shown in Fig. 6.

The blade 16B differs from the blade 16 of the first embodiment in that the blade 16B has no projection but has an entire rough surface 18a. More specifically, the body 18B of the blade 16b has the blade surface 18a, which is flat with no projection. Serrated microgrooves extending in the direction X shown in Fig. 3 are formed on the entire blade surface 18a.

In the second embodiment, when the wafer W is loaded on the body 18B, significant frictional force can be ensured between the wafer W and the body 18 because microgrooves are formed on the entire blade surface 18a. As a result, the wafer W can be retained with a suppressed displacement. In the second embodiment as shown in Fig. 7, the wafer-loading region 18b has the same height as the periphery 18c of the wafer-loading region 18b, as in the first embodiment. This can effectively prevent formation of defects on the wafer W and reduce the thickness of the body 18B. ,

As explained above, the periphery 18c of the wafer-loading region 18b on the blade surface 18a of the body 16B has a height not greater than that of the wafer-loading region 18b, whereby the blade 16B retains the wafer W in a roughened-surface region on the wafer-loading region 18b. More specifically, the blade 16B has a simple structure that retains the wafer W without vacuum suction. In addition, since the blade 16B to retain the wafer W has no receiving hole in the body 18, defects on the wafer W can be avoided.

The entire blade surface 18a does not have to be a roughened-surface region. A part of the wafer-loading region 18b may be a roughened-surface region. However, when the entire wafer-loading region 18b is a roughened-surface region, the blade has high wafer-retaining ability.

Since the blades 16 and 16B do not require vacuum suction, they can be applied to a cluster tool that transfers the wafer W either in vacuum or air.

The present invention should not be limited to the embodiments described above but can include a variety of modifications. For example, the number, the size, and the shape of the projections can be appropriately modified, if required. In addition, the size, the shape, and the extending direction of microgrooves formed by a surface roughening treatment can also be modified, if required. Furthermore, a blasting process can also be employed as the surface roughening treatment. A grinding process is preferred in view of ensuring sufficient retaining ability and high reproducibility.

### Brief Description of the Drawings

Fig. 1 is a schematic view illustrating a cluster tool in accordance with an embodiment of the present invention.
Fig. 2 is a perspective view illustrating a blade of the cluster tool in Fig. 1.
Fig. 3 is a view illustrating the state of a roughened projection of the blade in Fig. 2.
Fig. 4 is a schematic sectional view illustrating the blade in Fig. 2.
Fig. 5 is a schematic sectional view illustrating a blade in accordance with a conventional technique.
Fig. 6 is a perspective view illustrating a blade in accordance with a second embodiment of the present invention.
Fig. 7 is a schematic sectional view of the blade in Fig. 6.

## Claims

1. A wafer transfer blade (16) for transferring a wafer (W) loaded on the blade surface (18a) of a body (18) of the blade, projections (22) having top surfaces subjected to a surface roughening treatment being provided on the blade surface in a wafer-loading region (18b) of the body.

2. The wafer transfer blade according to claim 1, wherein the projections (22) and the body (18) comprise the same material.

3. The wafer transfer blade according to claim 1 or 2, wherein the projections (22) are integrated to the body.

4. The wafer transfer blade according to any one of claims 1 to 3, wherein each of the projections has serrated grooves formed by the surface roughening treatment and extending in one direction.

5. The wafer transfer blade according to claim 4, wherein the grooves on each projection extend in a direction substantially perpendicular to the rotational direction of the wafer transfer blade.

6. The wafer transfer blade according to claim 4 or 5, wherein the grooves on each projection are formed by grinding using #30-90 abrasive powder.

7. The wafer transfer blade according to any one of claims 1 to 3, wherein the projections (22) are subjected to sandblasting as the surface roughening treatment.

8. A wafer transfer blade (16B) for transferring a wafer (W) loaded on the blade surface of a body (18B) of the blade,
wherein at least a part of a wafer-loading region (18b) on the blade surface of the body is a roughened-surface region subjected to a surface roughening treatment.

9. The wafer transfer blade according to claim 8, wherein the periphery (18c) of the wafer-loading region has a height not greater than that of the wafer-loading region and/or wherein the wafer-loading region has the same height as the periphery of the wafer loading region.

10. The wafer transfer blade according to one of the claims 8 or 9, wherein the entire wafer-loading region (18b) is the roughened-surface region.

11. The wafer transfer blade according to one of the claims 8 to 10, wherein the roughened-surface region has serrated grooves formed by the surface roughening treatment and extending in one direction.

12. The wafer transfer blade according to claim 11, wherein the grooves formed on the roughened-surface region extend in a direction substantially perpendicular to the rotational direction of the wafer transfer blade.

13. The wafer transfer blade according to claim 11 or 12, wherein the grooves formed on the roughened-surface region are processed by grinding using #30-90 abrasive powder.

14. The wafer transfer blade according to one of the claims 8 or 11, wherein the roughened-surface region is formed by sandblasting as the surface roughening treatment.

15. Method for fabricating a wafer transfer blade, in particular according to one of the claims 1 to 7, comprising:
providing a wafer transfer blade for transferring a wafer loaded on the blade surface of a body of the blade, projections being provided on the blade surface in a wafer-loading region of the body,
roughening top surfaces of the projections.
